Europäisches Patentamt

European Patent Office

Office européen des brevets

(19)

(11) Numéro de publication: **0 369 858**
**A1**

## DEMANDE DE BREVET EUROPEEN

(21) Numéro de dépôt: 89403073.3

(51) Int. Cl.5: **H03D 13/00**

(22) Date de dépôt: **08.11.89**

(30) Priorité: **15.11.88 FR 8814801**

(43) Date de publication de la demande:
**23.05.90 Bulletin 90/21**

(84) Etats contractants désignés:
**DE GB IT**

(71) Demandeur: **THOMSON-CSF**
**51, Esplanade du Général de Gaulle**
**F-92800 Puteaux(FR)**

(72) Inventeur: **Lazarus, Michel**
**THOMSON-CSF SCPI-Cédex 67**
**F-92045 Paris La Défense(FR)**

(74) Mandataire: **Albert, Claude et al**
**THOMSON-CSF SCPI**
**F-92045 PARIS LA DEFENSE CEDEX 67(FR)**

(54) Détecteurs de phase et de fréquence à dynamique étendue et faible bruit.

(57) Un détecteur de phase et de fréquence selon l'invention comprend des moyens caractéristiques constitués par un circuit de détection de déphasage (5) et un circuit de sommation et conversion en courant (6). Un circuit logique (1) délivre une pluralité de signaux logiques ($U_0$ à $U_2$, $D_0$ à $D_2$) représentatifs d'un déphasage ($\Phi$) entre des signaux d'entrée ($E_u$, $E_d$) compris dans une dynamique de mesure de $-2(K+1)\pi$ à $+2(K+1)\pi$, K étant un entier quelconque. Le circuit de sommation et conversion inclus différentes sources de courant de référence commandées respectivement par les signaux logiques et connectées à deux lignes de sommation de courant fournissant respectivement deux courants de mesure différentiels ($I_-$, $I_+$). Le circuit de détection de déphasage détecte un déphasage compris dans une dynamique réduite de $-2\pi$ à $+2\pi$ afin de commander dans le circuit de sommation et conversion la désactivation de sources de courant correspondant à des signaux logiques non significatifs dans la dynamique réduite. La désactivation desdites sources améliore le rapport signal/bruit d'un signal de mesure produit par un amplificateur différentiel (3) à partir des deux courants de mesure. Ce détecteur est réalisable sous forme de circuit intégre.

FIG.5

## Détecteurs de phase et de fréquence à dynamique étendue et faible bruit

La présente invention concerne la détection de phase et de fréquence dans le domaine de la synthèse de fréquence en général et notamment dans les circuits à boucle de verrouillage de phase. Plus particulièrement, l'invention concerne des détecteurs de phase et de fréquence à dynamique étendue et à faible bruit conçus pour des réalisations sous forme de circuits intégrés et pouvant être inclus dans des boîtiers ne dépassant pas 14 broches.

La demande de brevet FR-A-2 598 869 décrit un détecteur de phase et de fréquence présentant une dynamique de mesure étendue comprise entre -2(K+1)π et +2(K+1)π, K étant un entier quelconque. Ce détecteur présente les inconvénients suivants:
- un rapport signal/bruit du signal de mesure qui se dégrade sensiblement lorsque le paramètre K atteint des valeurs élevées et cela notamment dans la partie de la dynamique de mesure comprise entre -2π et +2π ;
- une programmation d'un facteur de pente relatif à une courbe de réponse du détecteur qui est peu commode du fait qu'il est nécessaire d'affecter des valeurs déterminées à toutes les résistances de deux réseaux de K+1 résistances chacun ; et
- un grand nombre de bornes de sorties dû au fait que les réseaux de résistances doivent être accessibles de l'extérieur afin notamment d'offrir à un utilisateur la possibilité de programmer le facteur de pente de la courbe de réponse du détecteur.

La présente invention vise à apporter des perfectionnements aux détecteurs de phase et de fréquence à dynamique étendue selon la technique antérieure afin de fournir des détecteurs de phase et de fréquence à dynamique étendue dans lesquels les inconvénients mentionnés ci-dessus sont éliminés.

A cette fin, un détecteur de phase et de fréquence selon l'invention pour mesurer dans une dynamique comprise entre -2(K+1)π et +2(K+1)π, où K est un entier quelconque, un déphasage entre des premier et second signaux d'entrée, ledit détecteur ayant des moyens recevant les signaux d'entrée et constitués à partir de 2(K+1) bascules en cascade pour produire K+1 premiers signaux logiques de mesure et K+1 seconds signaux logiques de mesure représentatifs du déphasage entre les signaux d'entrée, des moyens ayant des entrées reliés aux moyens pour produire et recevant les signaux logiques de mesure pour dériver des premier et second courants de mesure à partir desdits signaux, et des moyens pour soustraire les premier et second courants de mesure afin d'obtenir le signal de mesure représentatif du déphasage entre les signaux d'entrée, est caractérisé en ce qu'afin d'augmenter le rapport signal/bruit du signal de mesure lorsque le déphasage entre les signaux d'entrée est compris dans une dynamique réduite prédéterminée, il comprend également des moyens pour détecter un déphasage entre les signaux d'entrée compris dans la dynamique réduite, et des moyens commandés par les moyens pour détecter et associés aux moyens pour dériver pour éliminer toute contribution à la production des premier et second courants de mesure de signaux logiques de mesure non représentatifs du déphasage entre les signaux d'entrée lorsque celui-ci est compris dans la dynamique réduite (-2π à +2π).

Selon un mode de réalisation préféré les moyens pour dériver comprennent K+1 premières sources de courant et K+1 premiers commutateurs-inverseurs commandés respectivement par les K+1 premiers signaux logiques de mesure et reliant respectivement les premières sources de courant à des première et seconde lignes de sommation de courant délivrant respectivement les premier et second courants de mesure, et K+1 secondes sources de courant et K+1 seconds commutateurs-inverseurs commandés respectivement par les K+1 seconds signaux logiques de mesure et reliant respectivement les secondes sources de courant aux première et seconde lignes de sommation de courant, chacun des premiers commutateurs-inverseurs étant commandé par le premier signal logique de mesure correspondant de manière à aiguiller un courant de référence produit par la première source de courant correspondante vers la première ligne de sommation de courant en réponse à un premier état logique et vers la seconde ligne de sommation de courant en réponse à un second état logique, et chacun des seconds commutateurs-inverseurs étant commandé par le second signal logique de mesure correspondant de manière à aiguiller un courant de référence produit par la seconde source de courant correspondante vers la seconde ligne de sommation de courant en réponse au premier état logique et vers la première ligne de sommation de courant en réponse au second état logique, ainsi que des moyens pour régler l'amplitude des courants de référence délivrés par les sources de courant à des première et seconde valeurs prédéterminées, en fonction d'un signal de programmation.

L'invention sera mieux comprise à la lecture de la description suivante de plusieurs réalisations préférées de l'invention en référence aux dessins annexés correspondants dans lesquels :
- la Fig. 1 représente un détecteur de phase et de fréquence à dynamique étendue selon la technique antérieure ;

- les Figs. 2 et 3 montrent respectivement des courbes de réponse et des chronogrammes de fonctionnement relatifs au détecteur de phase et de fréquence à dynamique étendue ;

- la Fig. 4 montre une première réalisation préférée du détecteur de phase et de fréquence perfectionné selon l'invention ;

- la Fig. 5 est un bloc-diagramme montrant la structure générale de secondes réalisations préférées du détecteur perfectionné selon l'invention ;

- la Fig. 6 est un bloc-diagramme schématique d'un circuit de sommation et de conversion en courant inclus dans les secondes réalisations préférées du détecteur perfectionné selon l'invention ;

la Fig. 7 est un chronogramme de fonctionnement relatif au circuit de sommation et de conversion en courant; et

- la Fig. 8 est un bloc-diagramme détaillé d'une forme particulière de réalisation du circuit de sommation et de conversion en courant pour un détecteur perfectionné selon l'invention réalisé en circuit intégré.

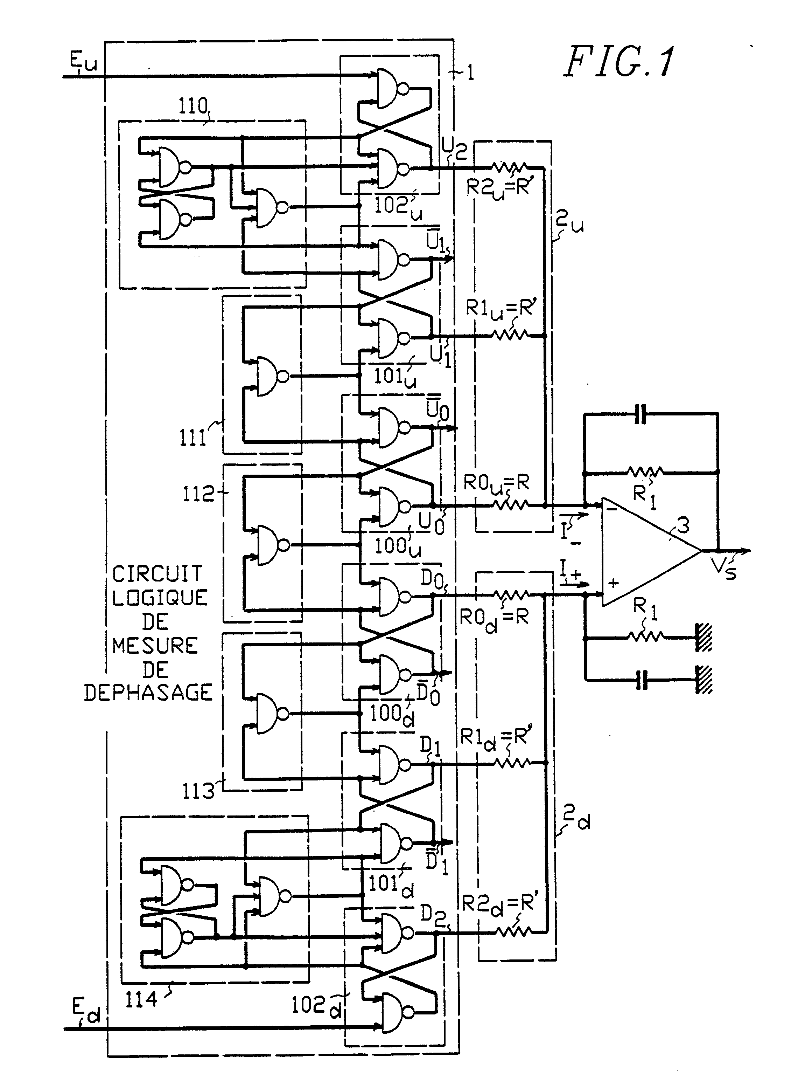

En référence à la Fig. 1, un détecteur de phase et de fréquence selon la demande de brevet FR-A-2 598 869 comprend un circuit logique de mesure de déphasage 1, deux réseaux analogues de résistances $2_u$ et $2_v$, et un amplificateur de sommation 3.

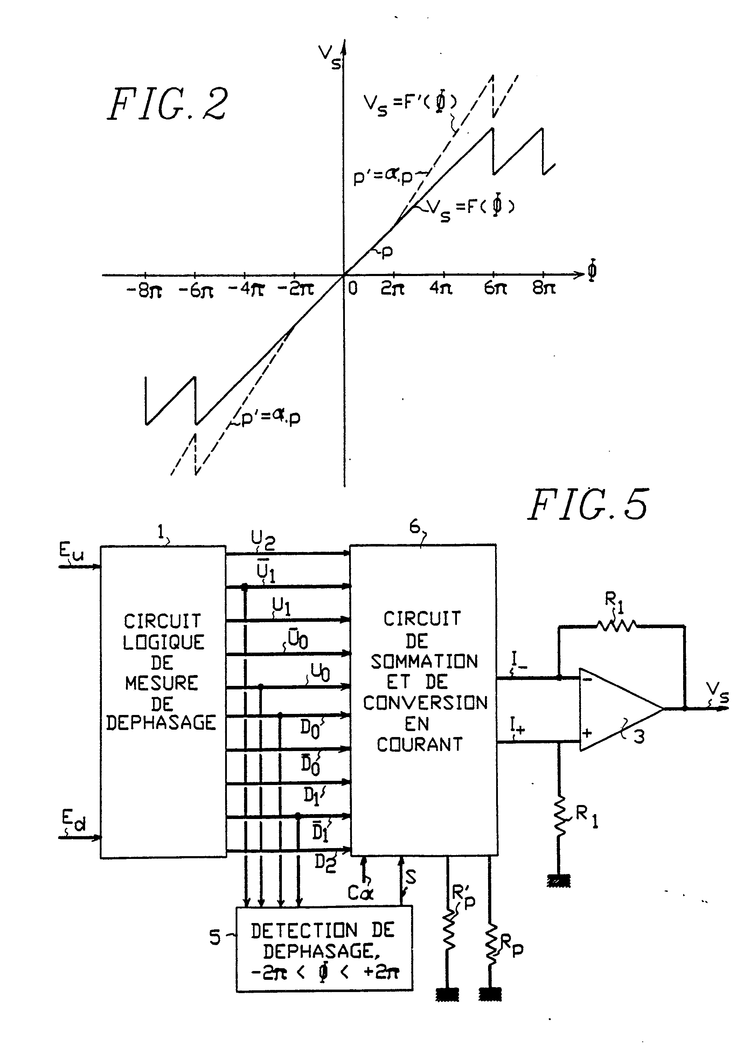

Le détecteur montré à la Fig. 1 est un détecteur de phase et de fréquence ayant une dynamique de mesure comprise entre $-2(K+1)\pi = -6\pi$ et $+2(K+1)\pi = +6\pi$, avec $K = 2$. Un tel détecteur présente une réponse utile pour des déphasages $\Phi$ entre des signaux d'entrée $E_u$ et $E_d$ compris entre $-6\pi$ et $+6\pi$. Des courbes de réponse $V_s = F(\Phi)$ et $V_s = F'(\Phi)$ du détecteur, où $V_s$ est le signal de mesure délivré par le détecteur, sont représentées à la Fig. 2.

Le circuit logique de mesure de déphasage 1 comprend $2(K+1) = 6$ bascules de mesure de déphasage $100_u$, $101_u$, $102_u$ et $100_d$, $101_d$ et $102_d$ de type RS, et cinq circuits de commande 110 à 114.

Les bascules $100_u$, $101_u$, et $102_u$ sont reliées en cascade par les circuits de commande 110 à 114 et délivrent respectivement des signaux logiques de mesure de déphasage $U_0$ et $\overline{U}_0$, $U_1$ et $\overline{U}_1$, et $U_1$, et $U_2$. Les bascules $100_d$, $101_d$, $102_d$ délivrent respectivement les signaux logiques de mesure de déphasage $D_0$ et $\overline{D}_0$, $D_1$ et $\overline{D}_1$ et $D_2$. Les signaux logiques de mesure $U_0$, $U_1$ et $U_2$ sont appliqués à des premières bornes respectivement de résistances $R0_u$, $R1_u$ et $R2_u$ du réseau $2_u$. Des secondes bornes des résistances $R0_u$, $R1_u$ et $R2_u$ sont reliées ensemble à une entrée inverse - de l'amplificateur 3. Les signaux logiques de mesure $D_0$, $D_1$ et $D_2$ sont appliqués à des premières bornes respectivement de résistances $R0_d$, $R1_d$ et $R2_d$ du réseau $2_d$. Des secondes bornes des résistances $R0_d$, $R1_d$ et $R2_d$ sont reliées ensemble à une entrée directe + de l'amplificateur 3. Des courants de mesure $I_-$ et $I_+$ obtenus par sommation directe respectivement des signaux logiques de mesure $U_0$ à $U_2$ et $D_0$ à $D_2$ sont ainsi fournis aux entrées inverse et directe - et + de l'amplificateur 3. Le signal de mesure $V_s$ est obtenu par soustraction des courants $I_-$ et $I_+$. Le signal de mesure $V_s$ est exprimé par la relation :
$V_s = R_1(I_+ - I_-)$,
où $R_1$ est la valeur de résistances de l'amplificateur 3 placées en contre-réaction et entre l'entrée directe + et une masse de référence.

Dans le cas où une même valeur R est affectée à toutes les résistances $R0_u$ à $R2_u$ et $R1_d$ à $R2_d$, il est obtenu la courbe de réponse $V_s = F(\Phi)$ présentant une même pente p dans toute la dynamique de mesure de $\Phi = -6\pi$ à $\Phi = +6\pi$. Dans le cas où la valeur R est affectée aux résistances $R0_u$ et $R0_d$ et qu'une valeur différente $R' = R/\alpha$, inférieure à la valeur R, est affectée aux autres résistances $R1_u$, $R2_u$ et $R1_d$, $R2_d$ il est obtenu la courbe de réponse $V_s = F'(\Phi)$ présentant la pente p dans la dynamique de mesure de $\Phi = -2\pi$ à $\Phi = +2\pi$ et la pente $p' = \alpha.p$ supérieure à p dans la dynamique de mesure de $\Phi = -6\pi$ à $\Phi = -2\pi$ et de $\Phi = +2\pi$ à $\Phi = +6\pi$, $\alpha$ étant un réel positif supérieur à 1.

Dans un tel détecteur de phase et de fréquence, les réseaux de résistances $2_u$ et $2_d$ représentent un inconvénient du fait qu'ils introduisent dans le signal de mesure $V_s$ un bruit d'autant plus important que le facteur K a une valeur élevée. La puissance de bruit $N_s^2$ dans le signal de mesure $V_s$ pour un détecteur dans lequel les résistances $R0_u$ à $R2_u$ et $R0_d$ à $R2_d$ ont toutes une même valeur R est exprimée par la relation suivante :
$N_s^2 = 8.K_0.T.R_1 + N_0^2.[1 + G. (1 + K)]^2 + (1 + K).G^2.(e_s^2 + 4.K_0 T.R)$, (1)
dans laquelle $K_0$, T, et G représentent respectivement la constante de Boltzmann, la température absolue en degrés Kelvin, et un gain de sommation déterminé par l'égalité $G = R_1/R$, et où $e_s^2$ et $N_0^2$ représentent respectivement une puissance de bruit correspondant aux signaux logiques de mesure $U_0$ à $U_2$ et $D_0$ à $D_2$ et une puissance de bruit introduite par l'amplificateur 3.

Cette égalité montre l'influence importante du facteur K sur les second et troisième termes de la somme (1) définissant la puissance de bruit $N_s^2$.

Par ailleurs, la programmation de deux pentes différentes p et $p' = \alpha.p$ dans la dynamique de mesure de $-2(K+1)\pi$ à $+2(K+1)\pi$ implique que les réseaux de résistances $2_u$ et $2_d$ soient accessibles à l'utilisateur du détecteur, et de ce fait l'intégration de ces réseaux de résistances dans un détecteur de phase et de fréquence réalisé sous forme de circuit intégré est impossible.

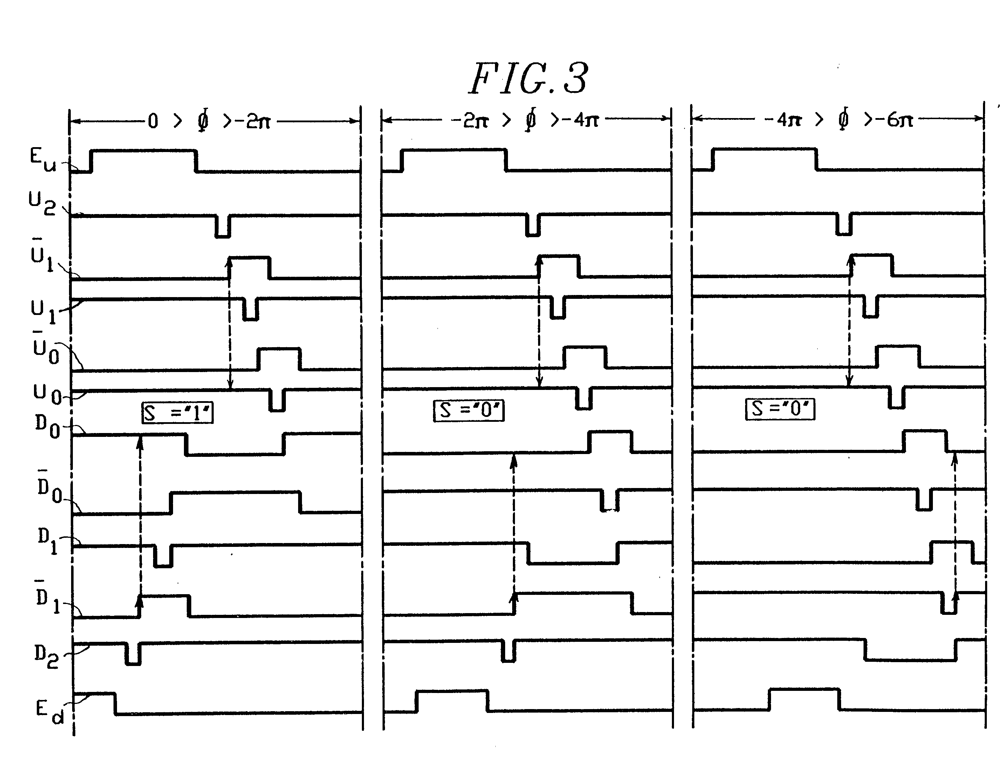

Il apparaît à l'étude des chronogrammes montrés à la Fig. 3 et relatifs aux formes d'onde des signaux logiques de mesure $U_0$ à $U_2$ et $D_0$ à $D_2$ et des signaux complémentaires $\overline{U}_0$, $\overline{U}_1$ et $\overline{D}_0$, $\overline{D}_1$ pour des déphasages $\Phi$ compris dans différentes parties de la dynamique de mesure, que dans le cas où le déphasage $\Phi$ est compris entre -$2\pi$ et 0, et 0 et +$2\pi$ du fait de la structure symétrique du circuit 1, les signaux logiques de mesure autre que $U_0$ et $D_0$, c'est-à-dire $U_1$, $U_2$ et $D_1$, $D_2$ dans cet exemple de réalisation où $K = 2$, ont la même forme d'onde et consécutivement leurs contributions respectives au signal de mesure $V_s$ s'annulent mutuellement après soustraction des courants de mesure $I_-$ et $I_+$ par l'amplificateur 3. Seuls les signaux logiques de mesure $U_0$ et $D_0$ contribuent donc à produire le signal de mesure $V_s$. Néanmoins, le bruit dû aux signaux $U_1$, $U_2$ et $D_1$, $D_2$ et aux résistances correspondantes $R1_u$, $R2_u$ et $R1_d$, $R2_d$ des réseaux $2_u$ et $2_d$ est injecté dans le signal de mesure $V_s$ et réduit le rapport signal/bruit dudit signal.

Lorsque le déphasage $\Phi$ est compris entre -$2\pi$ et +$2$, une solution simple pour réduire le bruit du signal de mesure $V_s$ est de déconnecter les résistances $R1_u$, $R2_u$ et $R1_d$, $R2_d$ des réseaux $2_u$ et $2_d$ du circuit logique de mesure de déphasage 1 afin d'éliminer dans le signal de mesure $V_s$ le bruit dû aux signaux $U_1$, $U_2$ et $D_1$, $D_2$ et auxdites résistances.

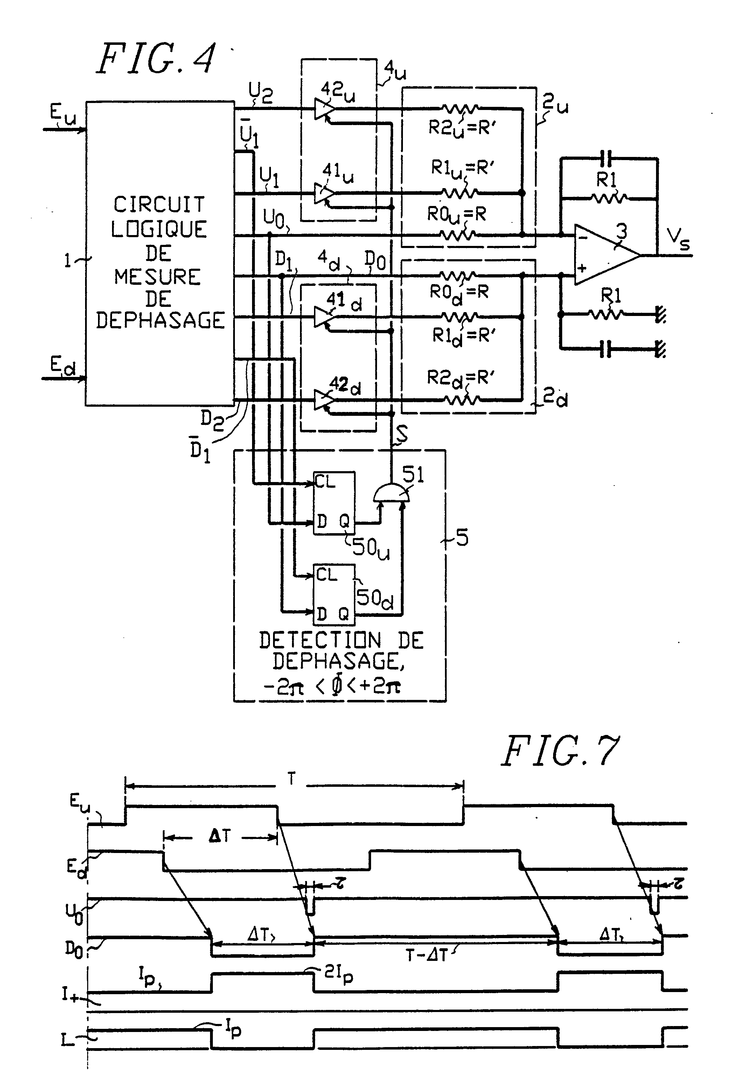

En référence à la Fig. 4, une première réalisation préférée d'un détecteur de phase et de fréquence perfectionné selon l'invention comprend un circuit logique de mesure de déphasage 1 analogue au circuit montré à la Fig. 1, deux réseaux de résistances $2_u$ et $2_d$, et un amplificateur de sommation 3, ainsi que des moyens supplémentaires constitués par deux ensembles analogues d'amplificateurs-buffers de type "tri-states" $4_u$ et $4_d$ et un circuit de détection de déphasage 5.

Les ensembles d'amplificateurs-buffers $4_u$ et $4_d$ reçoivent respectivement en entrée les signaux logiques de mesure $U_1$, $U_2$ et $D_1$, $D_2$.

L'ensemble d'amplificateurs-buffers $4_u$ (respectivement $4_d$) comprend deux amplificateurs-buffers $41_u$ et $42_u$ (respectivement $41_d$ et $42_d$) recevant respectivement en entrée les signaux $U_1$ et $U_2$ (respectivement $D_1$ et $D_2$) et reliés en sortie aux premières bornes des résistances $R1_u$ et $R2_u$ (respectivement $R1_d$ et $R2_d$). et Des entrées de commande de déconnexion des amplificateurs-buffers des deux ensembles $4_u$ et $4_d$ reçoivent un signal de commande S fournit par le circuit de détection de déphasage 5.

Le circuit de détection de déphasage 5 a pour fonction de détecter un déphasage $\Phi$ entre les signaux d'entrée $E_u$ et $E_d$ compris entre -$2\pi$ et

+$2\pi$. Le signal S indique à l'état logique "1" que le déphasage $\Phi$ est compris dans la dynamique réduite entre -$2\pi$ et +$2\pi$. Le signal S est produit par le circuit de détection 5 à partir des signaux logiques de mesure $U_0$ et $D_0$ et des signaux complémentaires $\overline{U}_1$ et $\overline{D}_1$.

Le circuit 5 comprend deux bascules $50_u$ et $50_d$ de type D et une porte logique ET à deux entrées 51. Les bascules $50_u$ et $50_d$ reçoivent respectivement les signaux $U_0$ et $D_0$ à des entrées de données D et les signaux complémentaires $\overline{U}_1$ et $\overline{D}_1$ à des entrées d'horloge CL. Des sorties Q des bascules $50_u$ et $50_d$ sont reliées respectivement à des première et seconde entrées de la porte 51. La porte 51 délivre en sortie le signal de commande S.

Les chronogrammes de la Fig. 3 montrent, pour des déphasages $\Phi$ compris entre 0 et -$2\pi$, -$2\pi$ et -$4\pi$, et -$4\pi$ et -$6\pi$, les états des signaux logiques de mesure $U_0$ et $D_0$ à des instants définis par des fronts montants des signaux complémentaires $\overline{U}_1$ et $\overline{D}_1$. Les états logiques des signaux $U_0$ et $D_0$ auxdits instants sont mémorisés respectivement par les bascules $50_u$ et $50_d$ du circuit de détection 5.

Comme il apparaît à l'étude des chronogrammes de la Fig. 3, les bascules $50_u$ et $50_d$ mémorisent toutes les deux un état "1" correspondant à l'état logique des signaux $U_0$ et $D_0$ aux instants définis par les fronts montants des signaux $\overline{U}_1$ et $\overline{D}_1$, et consécutivement le signal de commande S est à l'état "1", uniquement lorsque le déphasage $\Phi$ est compris entre -$2\pi$ et 0, ou 0 et +$2\pi$ du fait de la structure symétrique du circuit 1.

En fait, en toute rigueur, le signal S commute pour $\Phi = \pm 2\pi(1-3.\tau.F)$, où $\tau$ et F sont respectivement le temps de traversée des portes NON-ET constituant le circuit logique de mesure de déphasage 1 (Fig. 1) et la fréquence des signaux d'entrée $E_u$ et $E_d$. Toutefois la quantité $3.\tau.F$ est généralement négligeable (elle est de l'ordre de $6.10^{-3}$ pour F = 1 MHz et $\tau = 2$ ns) de sorte qu'il peut être considéré que le signal S = "1" représente bien un déphasage $\Phi$ compris entre -$2\pi$ et +$2\pi$.

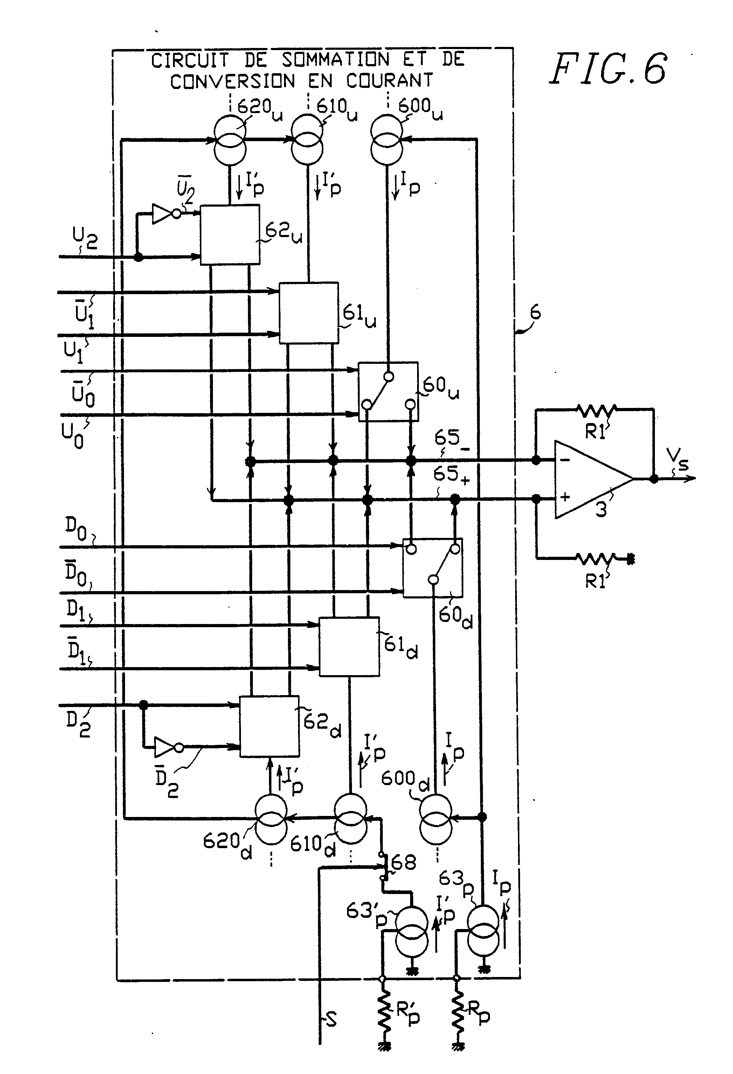

En référence aux Figs. 5 à 8, il est maintenant décrit des secondes réalisations préférées d'un détecteur de phase et de fréquence perfectionné selon l'invention.

La structure générale de ces secondes réalisations est montrée à la Fig. 5. Selon ces secondes réalisations, le détecteur comprend un circuit logique de mesure de déphasage 1, un amplificateur de sommation 3, un circuit de détection de déphasage 5 tel que montré à la Fig. 4, et un circuit de sommation et de conversion en courant 6.

Les circuits 1, 5 et 6 sont réalisables sous la forme d'un unique circuit intégré auquel sont associées uniquement deux résistances $R_p$ et $R'_p$ afin

de programmer le facteur de pente $\alpha$. Par ailleurs, selon ces secondes réalisations, le signal de mesure $V_s$ n'est pas dérivé d'une sommation directe des signaux logiques de mesure mais d'une sommation de courants de référence délivrés par des sources de courant incluses dans le circuit 6. Les sources de courant délivrent des courants stabilisés indépendants de tensions d'alimentation du détecteur et de ce fait le signal de mesure $V_s$ n'est pas tributaire d'éventuelles fluctuations de ces tensions d'alimentation.

Le circuit de sommation et de conversion en courant 6 reçoit en entrée les signaux logiques de mesure $U_0$ et $U_2$ et $D_0$ à $D_2$, les signaux complémentaires $\overline{U}_0$, $\overline{U}_1$ et $\overline{D}_0$, $\overline{D}_1$, le signal de commande S, et éventuellement un signal de programmation $C\alpha$, et délivre en sortie des courants de mesure $I_+$ et $I_-$. Les courants $I_+$ et $I_-$ sont appliqués respectivement aux entrées directe + et inverse - de l'amplificateur 3. Le signal de programmation $C\alpha$ est éventuellement prévu afin de permettre la sélection de l'une des courbes de réponse $V_s = F(\Phi)$ et $V_s = F'(\Phi)$.

Un circuit de sommation et de conversion en courant 6 de principe est montré schématiquement à la Fig. 6.

Ce circuit 6 de principe comprend essentiellement $2(K+1)=6$ commutateurs-inverseurs de courant $60_u$ à $62_u$ et $60_d$ à $62_d$, $2(K+1)=6$ sources de courant images $600_u$ à $620_u$ et $600_d$ à $620_d$ respectivement associées aux commutateurs-inverseurs $60_u$ à $62_u$ et $60_d$ à $62_d$, et deux sources de courant de commande $63_p$ et $63'_p$.

Les sources de courant images $600_u$ et $600_d$ fournissent aux commutateurs-inverseurs $60_u$ et $60_d$ des courants images de valeur égale à un premier courant de référence $I_p$ délivré par la source de courant de commande $63_p$. Le courant $I_p$ est déterminé par la valeur attribuée à la résistance de programmation $R_p$. Lorsque $\Phi < -2\pi$ ou $\Phi > +2\pi$ et que le signal de commande S est consécutivement à l'état "1", les sources de courant images $610_u$, $620_u$ et $610_d$, $620_d$ fournissent aux commutateurs-inverseurs $61_u$, $62_u$ et $61_d$, $62_d$ des courants images de valeur égale à un second courant de référence $I'_p$ délivré par la source de courant de commande $63'_p$. Le courant $I'_p$ est déterminé par la valeur attribuée à la résistance de programmation $R'_p$. Le rapport de résistances $R_p$ et $R'_p$ détermine le facteur de pente $\alpha$ en application de l'égalité :
$$\alpha = I'_p / I_p = R_p / R'_p.$$
En fonction des états des signaux logiques de mesure $(U_0, \overline{U}_0)$, $(U_1, \overline{U}_1)$, $(U_2, \overline{U}_2)$, et $(D_0, \overline{D}_0)$, $(D_1, \overline{D}_1)$, $(D_2, \overline{D}_2)$ commandant des commutations respectivement dans les commutateurs-inverseurs $60_u$, $61_u$, $62_u$, et $60_d$, $61_d$, $62_d$, les courants images fournis aux commutateurs-inverseurs sont aiguillés vers des lignes de sommation de courant $65_+$ et

$65_-$ respectivement reliées aux entrées directe et inverse + et - de l'amplificateur de sommation 3. Les signaux $U_0$, $U_1$, et $U_2$ aux états "0" et "1" commandent l'aiguillage des courants images respectivement vers les lignes de sommation de courant $65_-$ et $65_+$. Les signaux $D_0$, $D_1$ et $D_2$ aux états "0" et "1" commandent l'aiguillage des courants images respectivement vers les lignes de sommation de courant $65_-$ et $65_+$. Les lignes de sommation de courant $65_+$ et $65_-$ convoient ainsi respectivement les courants de mesure $I_+$ et $I_-$ constitués par les sommes des différents courants images délivrés par les commutateurs-inverseurs de courant.

Des moyens pour désactiver les sources de courant $610_u$, $620_u$ $610_d$ et $620_d$ lorsque le signal de commande S est à l'état "1" sont représentés schématiquement à la Fig. 6 sous la forme d'un interrupteur 68.

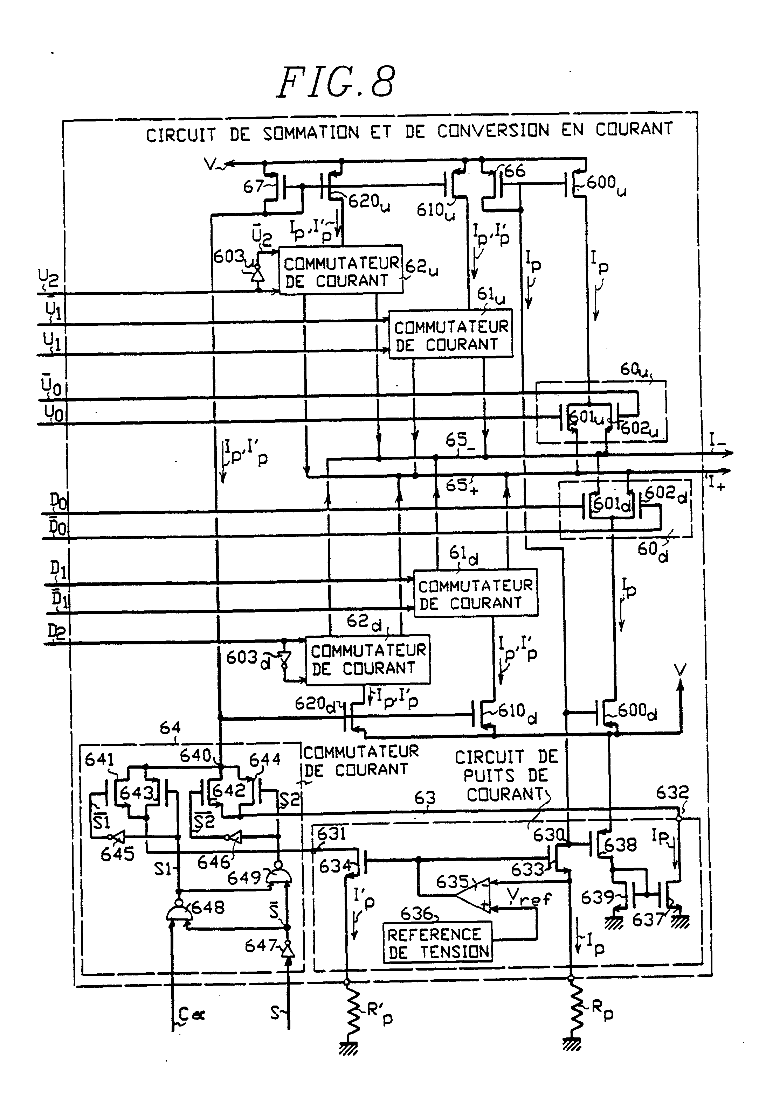

En référence également à la Fig. 7, il est considéré un déphasage $\Phi$ entre les signaux d'entrée $E_u$ et $E_d$ compris entre $-2\pi$ et 0. A ce déphasage $\Phi$ étant correspond un décalage temporel $\Delta T$ entre les signaux d'entrée $E_u$ et $E_d$.

Le déphasage $\Phi$ compris entre $-2\pi$ et 0, les sources de courant images $600_u$ et $600_d$ sont les seules actives et injectent des courants images égaux au courant de référence $I'_p$ dans les lignes de sommation de courant $65_+$ et $65_-$, à travers les commutateurs-inverseurs $60_u$ et $60_d$. Le signal logique de mesure $D_0$ commandant le commutateur $60_d$ comprend des premières périodes à l'état "0" de durée $\Delta T$ et des secondes périodes à l'état "1" de durée $T - \Delta T$, où $T = 1/F$ est la période des signaux d'entrée $E_u$ et $E_d$. Le signal logique de mesure $U_0$ commandant le commutateur $60_u$ est considéré constamment à l'état "1", les impulsions à l'état "0" de durée égale au temps de traversée $\tau$ étant négligeables.

Pendant les premières périodes de durée $\Delta T$ du signal $D_0$, les commutateurs-inverseurs $60_d$ et $60_u$ délivrent chacun un courant image égal à $I_p$ dans la ligne de sommation de courant $65_+$ et consécutivement le courant $I_+$ est égal à $2I_p$ et le courant $I_-$ est nul. L'amplitude du signal de mesure $V_s$ délivré par l'amplificateur 3 pendant ces premières périodes est exprimée par l'égalité :
$$V_s = (I_+ - I_-).R = 2I_p.R \qquad (2)$$
Pendant les secondes périodes de durée $T - \Delta T$ du signal $D_0$, les commutateurs-inverseurs $60_d$ et $60_u$ délivrent le courant image égal à $I_p$ respectivement dans les lignes de sommation de courant $65_-$ et $65_+$. L'amplitude du signal de mesure $V_s$ délivré par l'amplificateur 3 pendant ces secondes périodes est exprimée par l'égalité :
$$V_s = (I_+ - I_-).R = 0 \qquad (3)$$
Des égalités (2) et (3) découle l'amplitude moyenne du signal de sortie :

$V_s = 2R.I_p.(\Delta T/T) = R.I_p.(\Phi/\pi)$.

L'intérêt de l'aiguillage de courant réalisé par les commutateurs-inverseurs, par rapport à un circuit 6 ne comprenant pas d'inversion de courant et dans lequel les sources de courant images $600_u$ à $620_u$ et $600_d$ à $620_d$ sont reliées ou non respectivement aux lignes $65_-$ et $65_+$ en fonction des signaux $U_0$ à $U_2$ et $D_0$ à $D_2$, réside dans le fait que les pentes $p$ et $p'$ des courbes de réponse sont doublées en amplitude. Par ailleurs, les sources de courant débitent toujours dans l'une ou l'autre des lignes de sommation de courant et fonctionnent en régime stable, d'où une meilleure précision dans l'amplitude des courants images fournis.

Une réalisation en circuit intégré de technologie MOSFET d'un circuit 6 prévu pour recevoir le signal de programmation $C\alpha$ est maintenant décrite en détail en référence à la Fig. 8.

Le circuit 6 comprend essentiellement $2(K+1) = 6$ commutateurs-inverseurs de courant $60_u$ à $62_u$ et $60_d$ à $62_d$, $2(K+1) = 6$ sources de courant images $600_u$ à $620_u$ et $600_d$ à $620_d$ constituées de transistor MOSFET à canal P, un circuit de puits de courant 63 et un commutateur de commande 64.

Les commutateurs-inverseurs de courant $60_u$ et $60_d$ sont montrés en détail.

Le commutateur-inverseur $60_u$ comprend deux transistors $601_u$ et $602_u$ de type MOSFET à canal N. Des électrodes de drain des transistors $601_u$ et $602_u$ sont reliés ensemble à une électrode de drain de la source de courant image $600_u$. Des électrodes de grille des transistors $601_u$ et $602_u$ reçoivent respectivement les signaux logiques de mesure $U_0$ et $\overline{U}_0$. Des électrodes de source des transistors $601_u$ et $602_u$ sont reliées respectivement aux lignes de sommation de courant $65_+$ et $65_-$ convoyant respectivement les courants de mesure $I_+$ et $I_-$. Les autres $K = 2$ commutateurs-inverseurs $61_u$ et $62_u$ reçoivent respectivement les signaux logiques de mesure $U_1$, $\overline{U}_1$ et $U_2$, $\overline{U}_2$ et sont reliés aux sources de courant images correspondantes $610_u$ et $620_u$ et aux lignes de sommation de courant $65_+$ et $65_-$ de manière analogue au commutateur-inverseur de courant $60_u$.

Le commutateur-inverseur $60_d$ comprend également deux transistors $601_d$ et $602_d$ de type MOSFET à canal N. Des électrodes de drain des transistors $601_d$ et $602_d$ sont reliés ensemble à une électrode de drain de la source de courant image correspondante $600_d$. Des électrodes de grille des transistors $601_d$ et $602_d$ reçoivent respectivement les signaux logiques de mesure $D_0$ et $\overline{D}_0$. Des électrodes de source des transistors $601_d$ et $602_d$ sont reliées respectivement aux lignes de sommation de courant $65_-$ et $65_+$. Les autres $K = 2$ commutateurs-inverseurs $61_d$ et $62_d$ reçoivent respectivement les signaux logiques de mesure $D_1$, $\overline{D}$

$_1$ et $D_2$, $\overline{D}_2$ et sont reliés aux sources de courant images correspondantes $610_d$ et $620_d$ et aux lignes de sommation de courant $65_-$ et $65_+$ de manière analogue au commutateur-inverseur $60_d$.

Des inverseurs logiques $603_u$ et $603_d$ sont prévus dans le circuit 6 afin de produire à partir des signaux logiques de mesure $U_2$ et $D_2$ respectivement les signaux complémentaires $\overline{U}_2$ et $\overline{D}_2$ délivrés aux commutateurs de courant $62_u$ et $62_d$.

Les sources de courant images $600_u$ à $620_u$ et $600_d$ à $620_d$ ont des électrodes de source portées à une tension d'alimentation continue V.

Les électrodes de grille des sources de courant images $600_u$ et $600_d$ sont connectées ensemble aux électrodes de grille et de drain d'un transistor 66 de type MOSFET à canal P monté en diode. Une électrode de source du transistor 66 est portée à la tension V. Les électrodes de grille et de drain du transistor 66 sont reliées ensemble à une première sortie 630 du circuit de puits de courant 63. Le circuit 63 force le passage du premier courant de référence $I_p$ à travers le transistor 66. Le transistor 66 polarise en tension les électrodes de grille des sources de courant images $600_u$ et $600_d$ à une tension correspondant à un courant de drain égal au courant $I_p$.

Les électrodes de grille des sources de courant images $610_u$, $620_u$ et $610_d$, $620_d$ sont connectées ensemble aux électrodes de grille et de drain d'un autre transistor 67 de type MOSFET à canal P monté en diode. Une électrode de source du transistor 67 est portée à la tension V. Les électrodes de grille et de drain du transistor 67 sont reliées ensemble à une sortie 640 du commutateur de commande 64.

En fonction des états des signaux de commande et de programmation S et $C\alpha$, le commutateur de commande 64 connecte la sortie 640 à une seconde sortie 631 ou une troisième sortie 632 du circuit de puits de courant 63.

Lorsque la sortie 640 du commutateur de commande 64 est connectée à la seconde sortie 632 du circuit 63, le transistor 67 est traversé par le second courant de référence $I'_p$ et consécutivement les sources de courant images $610_u$, $620_u$ et $610_d$, $620_d$ délivrent respectivement aux commutateurs-inverseurs $61_u$, $62_u$ et $61_d$, $62_d$ des courants images égaux au second courant $I'_p$.

Lorsque la sortie 640 du commutateur de commande 64 est connectée à la seconde sortie 631 du circuit 63, le transistor 67 est traversé par le second courant de référence $I_p$ et consécutivement les sources de courant images $610_u$, $620_u$ et $610_d$, $620_d$ délivrent respectivement aux commutateurs-inverseurs de courant $61_u$, $62_u$ et $61_d$, $62_d$ des courants images égaux au premier courant $I_p$.

Le circuit de puits de courant 63 comprend des premier et second puits de courant 633 et 634 constitués par des transistors de type MOSFET à canal N, un amplificateur différentiel 635 de type à transconductance, et un circuit de référence de tension 636 de type "bandgap", ainsi qu'un troisième puits de courant 637 constitué par un transistor de type MOSFET à canal N, et deux transistors auxiliaires 638 et 639 de type MOSFET respectivement à canal P et canal N.

Le premier puits de courant 633 comprend des électrodes de drain et de source reliées respectivement à la première sortie 630 du circuit 63 et à une première borne de la résistance de programmation $R_p$ dont une seconde borne est reliée à la masse de référence. Une électrode de grille du transistor 633 est reliée ainsi qu'une électrode de grille du second puits de courant 634 à une sortie de l'amplificateur différentiel 635.

Le second puits de courant 634 comprend des électrodes de drain et de source reliées respectivement à la seconde sortie 631 du circuit 63 et à une première borne de la résistance de programmation $R'_p$ dont une seconde borne est reliée à la masse de référence.

L'amplificateur différentiel 635 comprend une entrée inverse -reliée à l'électrode de source du puits de courant 633 et à la première borne de la résistance $R_p$ et une entrée directe + recevant une tension de référence $V_{réf}$ délivrée par le circuit de référence de tension 636.

L'amplificateur 635 commande les électrodes de grille des puits de courant 633 et 634 en fonction d'une tension d'erreur entre ses entrées directe + et inverse - de manière à obtenir des tensions égales à la tension $V_{réf}$ au niveau des électrodes de source des puits de courant 633 et 634.

Les électrodes de source des puits de courant 633 et 634 étant stabilisées à la tension $V_{réf}$, les résistances $R_p$ et $R'_p$ programment les premier et second courants de référence $I_p$ et $I'_p$ respectivement aux valeurs $I_p = V_{réf}/R_p$ et $I'_p = V_{réf}/R'_p$.

Le troisième puits de courant 637 comprend des électrodes de drain et de source respectivement connectées à la troisième sortie 632 du circuit 63 et à la masse de référence. Une électrode de grille du puits de courant 637 est polarisée à une tension correspondant à un courant de drain égal au courant $I_p$ par les transistors auxiliaires 638 et 639.

Le transistor auxiliaire 638 comprend une électrode de source portée à la tension d'alimentation continue V et une électrode de grille reliée à la première sortie 630 du circuit 63. Une électrode de drain du transistor auxiliaire 638 est reliée à des électrodes de drain et de grille du transistor auxiliaire 639 monté en diode. Les électrodes de drain et de grille du transistor auxiliaire 639 sont connectées ensemble à l'électrode de grille du troisième puits de courant 637. Une électrode de source du transistor auxiliaire 639 est reliée à la masse de référence.

Le commutateur de commande 64 comprend deux transistors 641 et 642 de type MOSFET à canal N, deux transistors 643 et 644 de type MOSFET à canal P, trois inverseurs logiques 645, 646 et 647, et deux portes NON-ET à deux entrées chacune 648 et 649.

Les électrodes de source et de drain respectivement des transistors 641 et 643 sont reliées ensemble à la seconde sortie 631 du circuit de puits de courant 63. Les électrodes de source et de drain respectivement des transistors 642 et 644 sont reliées ensemble à la troisième sortie 632 du circuit de puits de courant 63. Les électrodes de drain et de source respectivement des transistors 641, 642 et 643, 644 sont reliées ensemble à la sortie 640 du commutateur de commande 64.

Des signaux de commande S1 et S2 sont produits respectivement par les portes 648 et 649. Les signaux S1 et S2 sont appliqués à des électrodes de grille respectivement des transistors 643 et 644. Des signaux de commande complémentaires $\overline{S1}$ et $\overline{S2}$ sont produits par les inverseurs 645 et 646 et sont appliqués à des électrodes de grille respectivement des transistors 641 et 642.

Le signal de programmation $C\alpha$ est appliqué à une première entrée de la porte 648. Une seconde entrée de la porte 648 reçoit un signal de commande complémentaire $\overline{S}$ produit par l'inverseur 647 à partir du signal de commande S. La porte 648 délivre en sortie le signal de commande $S1 = C\alpha + S$.

Les états logiques "0" et "1" du signal de programmation $C\alpha$ sélectionnent respectivement les courbes de réponse $V_s = F(\Phi)$ et $V_s = F'(\Phi)$.

En effet, lorsque le signal de programmation $C\alpha$ est à l'état "0", le signal de commande S1 est à l'état "1" et $S2 = S$. Le signal $S1 = "1"$ bloque les transistors 641 et 643 et interdit la polarisation des grilles des sources de courant images $610_u$, $620_u$ et $610d$, $620_d$ à une tension correspondant au courant $I'_p$. Lorsque $-2\pi < \Phi < 2\pi$, le signal $S2 = S = "1"$ bloque les transistors 642 et 644 et interdit la polarisation des sources de courant images 610u, $620_u$ et $610_d$, $620_d$ à une tension correspondant au courant Ip. Seules les sources de courant images $600_u$ et $600_d$ sont alors polarisées et fournissent le courant Ip aux commutateurs et 60 et $60_d$ Lorsque $\Phi < -2\pi$ ou $\Phi > 2\pi$, le signal $S2 = S = "0"$ sature les transistors 642 et 644 et les sources de courant images $610_u$, $620_u$ et 610d, $620_d$ délivrent le courant $I_p$ aux commutateurs-inverseurs $61_u$, $62_u$ et 61d, $62_d$. La courbe $V_s = F(\Phi)$ est donc obtenue dans ce premier cas où le signal $C\alpha = "0"$.

Lorsque le signal de programmation $C\alpha$ est à l'état "1", les signaux S1 et S2 sont exprimés par les égalités :
S1 = S et S2 = "1".

Le signal S2 = "1" bloque les transistors 642 et 644 et interdit la polarisation des sources de courant images 610u, 620$_u$ et 610$_d$, 620$_d$ à une tension correspondant au courant Ip. Lorsque $-2\pi < \Phi < 2\pi$, le signal S1 = S = "1" bloque les transistors 641 et 643. Seules les sources de courant images 600$_u$ et 600$_d$ sont alors polarisées et fournissent le courant I$_p$ aux commutateurs-inverseurs 60$_u$ et 60$_d$. Lorsque $\Phi < -2\pi$ ou $\Phi > 2\pi$, le signal S1 = S = "0" sature les transistors 641 et 643 et les sources de courant images 610u, 620$_u$ et 610$_d$, 620$_d$ délivrent le courant I'$_p$ aux commutateurs 61$_u$, 62$_u$ et 61$_d$, 62$_d$. La courbe V$_s$ = F'($\Phi$) est donc obtenue dans ce second cas où le signal C$\alpha$ = "1".

Les réalisations décrites ci-dessus de détecteurs de phase et de fréquence selon l'invention doivent être considérées comme des exemples. D'autres réalisations sont bien entendu possibles notamment en technologie ECL pour des fréquences de fonctionnement élevées.

**Revendications**

1. Détecteur de phase et de fréquence pour mesurer dans une dynamique comprise entre -2-(K + 1)π et +2(K + 1)π, où K est un entier quelconque, un déphasage ($\Phi$) entre des premier et second signaux d'entrée (E$_d$, E$_u$), ledit détecteur ayant des moyens (1) recevant les signaux d'entrée (E$_d$, E$_u$) et constitués à partir de 2(K + 1) bascules en cascade (100$_d$ à 102$_d$ et 100$_u$ à 102$_u$) pour produire K + 1 premiers signaux logiques de mesure (D$_0$ à D$_2$) et K + 1 seconds signaux logiques de mesure (U$_0$ à U$_2$) représentatifs du déphasage ($\Phi$) entre les signaux d'entrée (E$_d$, E$_u$), des moyens (2$_d$, 2$_u$) ayant des entrées reliées aux moyens pour produire (1) et recevant les signaux logiques de mesure (D$_0$ à D$_2$ et U$_0$ à U$_2$) pour fournir des courants déterminés par ces signaux logiques et en dériver par sommation des premier et second courants de mesure (I$_+$, I$_-$) à partir desdits signaux, et des moyens (3) pour soustraire les premier et second courants de mesure (I$_+$, I$_-$) afin d'obtenir le signal de mesure (V$_s$) représentatif du déphasage ($\Phi$) entre les signaux d'entrée (E$_d$, E$_u$), caractérisé en ce qu'afin d'augmenter le rapport signal/bruit du signal de mesure (V$_s$) lorsque le déphasage $\Phi$) entre les signaux d'entrée (E$_d$, E$_u$) est compris dans une dynamique réduite prédéterminé (-2π à + 2π), il comprend également des moyens (5) pour détecter un déphasage ($\Phi$) entre les signaux d'entrée (E$_d$, E$_u$) compris dans la dynamique réduite (-2π à + 2π), et des moyens (4$_d$, 4$_u$) commandés par les moyens pour détecter (5) et associés aux moyens pour dériver (2$_d$, 2$_u$, 6) pour

éliminer toute contribution à la production des premier et second courants de mesure (I$_+$, I$_-$) de signaux logiques de mesure (D$_1$, U$_1$ et D$_2$, U$_2$) non représentatifs du déphasage ($\Phi$) entre les signaux d'entrée (E$_d$, E$_u$) lorsque celui-ci est compris dans la dynamique réduite (-2π à + 2π).

2. Détecteur de phase et de fréquence conforme à la revendication 1) dans lequel les moyens pour dériver comprennent des réseaux de résistances (2$_d$, 2$_u$) destinés à produire les courants de mesure (I$_+$, I$_-$) à partir des signaux logiques de mesure (D$_0$ à D$_2$ et U$_0$ à U$_2$), caractérisé en ce que les moyens pour éliminer comprennent des amplificateurs-buffers (4$_d$, 4$_u$) de type tri-states à travers lesquels sont appliqués aux réseaux de résistances (2$_d$, 2$_u$) des signaux logiques de mesure (D$_1$, U$_1$ ; D$_2$, U$_2$) non représentatifs du déphasage ($\Phi$) entre les signaux d'entrée (E$_d$, E$_u$) lorsque celui-ci est compris dans la dynamique réduite (-2π à + 2π), lesdits amplificateurs-buffers (2$_d$, 2$_u$) étant commandés par les moyens pour détecter (5) de manière à déconnecter leurs sorties des réseaux de résistances (2$_d$, 2$_u$) lorsqu'un déphasage ($\Phi$) entre les signaux d'entrée (E$_d$, E$_u$) compris dans la dynamique réduite (-2π à + 2π) est détecté.

3. Détecteur de phase et de fréquence conforme à la revendication 1, caractérisé en ce que les moyens pour dériver (6) comprennent K + 1 premières sources de courant (600$_d$ à 620$_d$) commandées respectivement par les K + 1 premiers signaux logiques de mesure (D$_0$ à D$_2$) et reliées à une première ligne de sommation de courant (65$_+$) pour produire le premier courant de mesure (I$_+$) et K + 1 secondes sources de courant (600$_u$ à 620$_u$) commandées respectivement par les K + 1 seconds signaux logiques de mesure (U$_0$ à U$_2$) et reliées à une seconde ligne de sommation de courant (65$_-$) pour produire le second courant de mesure (I$_-$), les signaux logiques de mesure (D$_0$ à D$_2$ et U$_0$ à U$_2$) activant et désactivant selon leurs états logiques ("0", "1") les sources de courant (60$_d$ à 62$_d$ et 60$_u$ à 62$_u$) afin de commander la transmission par chacune des sources de courant activées d'un courant de référence (I$_p$, I'$_p$) dans la ligne de sommation de courant correspondante (65$_+$, 65$_-$).

4. Détecteur de phase et de fréquence conforme à la revendication 1, caractérisé en ce que les moyens pour dériver (6) comprennent K + 1 premières sources de courant (600$_d$ à 620$_d$) et K + 1 premiers commutateurs-inverseurs (60$_d$ à 62$_d$) commandés respectivement par les K + 1 premiers signaux logiques de mesure (D$_0$ à D$_2$) et reliant respectivement les premières sources de courant (600$_d$ à 620$_d$) à des première et seconde lignes de sommation de courant (65$_+$ et 65$_-$) délivrant respectivement les premier et second courants de mesures (I$_+$ et I$_-$), K + 1 secondes sources de courant (600$_u$ à 620$_u$) et K + 1 seconds

commutateurs-inverseurs ($60_u$ à $62_u$) commandés respectivement par les K + 1 seconds signaux logiques de mesure ($U_0$ à $U_2$) et reliant respectivement les secondes sources de courant ($600_u$ à $620_u$) aux première et seconde lignes de sommation de courant ($65_+$ et $65_-$) chacun des premiers commutateurs-inverseurs ($60_d$ à $62_d$) étant commandé par le premier signal logique de mesure correspondant ($D_0$ à $D_2$) de manière à aiguiller un courant de référence ($I_p$, $I'_p$) produit par la première source de courant correspondante ($600_d$ à $620_d$) vers la première ligne de sommation de courant ($65_+$) en réponse à un premier état logique ("0") et vers la seconde ligne de sommation de courant ($65_-$) en réponse à un second état logique ("1"), et chacun des seconds commutateurs-inverseurs ($60_u$ à $62_u$) étant commandé par le second signal logique de mesure correspondant ($U_0$ à $U_2$) de manière à aiguiller un courant de référence ($I_p$, $I'_p$) produit par la seconde source de courant correspondante ($600_u$ à $620_u$) vers la seconde ligne de sommation de courant ($65_-$) en réponse au premier état logique ("o") et vers la première ligne de sommation de courant ($65_+$) en réponse au second état logique ("1").

5. Détecteur de phase et de fréquence conforme à la revendication 3 ou 4, caractérisé en ce que les moyens pour éliminer comprennent des moyens (68, 64) pour désactiver les sources de courant correspondantes ($610_d$, $620_d$ ; $610_u$, $620_u$) lorsque le déphasage ($\Phi$) entre les signaux d'entrée ($E_d$, $E_u$) est compris dans la dynamique réduite (-2$\pi$ à +2$\pi$).

6. Détecteur de phase et de fréquence conforme à l'une quelconque des revendications 3 à 5, caractérisé en ce que les moyens pour dériver (6) comprennent des moyens (63, 64) pour régler l'amplitude des courants de référence délivrés par les sources de courant ($60_d$ à $62_d$ et $60_u$ à $62_u$) à des première et seconde valeurs prédéterminées ($I_p$, $I'_p$), en fonction d'un signal de programmation (C ).

7. Détecteur conforme à l'une quelconque des revendications 1 à 6, caractérisé en ce que ladite dynamique réduite est comprise entre -2$\pi$ et +2$\pi$.

8. Détecteur conforme à l'une quelconque des revendications 1 à 7, caractérisé en ce qu'il comprend un circuit intégré incluant les moyens pour produire (1), les moyens pour dériver (6) et les moyens pour détecter (5).

*FIG.1*

CIRCUIT
LOGIQUE
DE
MESURE
DE
DEPHASAGE

*FIG.2*

*FIG.5*

FIG.3

EP 0 369 858 A1

FIG. 4

FIG. 7

FIG.6

# FIG.8

CIRCUIT DE SOMMATION ET DE CONVERSION EN COURANT

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | EP-A-0 283 160  (MARCONI INSTRUMENTS LTD)<br>* Colonne 4, ligne 53 - colonne 5, ligne 27; figures 8-10 *<br>--- | 1,3,5,7 ,8 | H 03 D  13/00 |
| Y,D | EP-A-0 246 135  (THOMSON-CSF)<br>* Page 3, ligne 46 - page 7, ligne 4; Figures 2-10 * | 1,3,5,7 ,8 | |
| A | --- | 2 | |
| A | EP-A-0 190 894  (ADVANCED MICRO DEVICES, INC.)<br>* Colonne 3, ligne 61 - colonne 9, ligne 29; figures 1-3 *<br>----- | 6 | |

|  | DOMAINES TECHNIQUES RECHERCHES (Int. Cl.5) |
|---|---|
| | H 03 D<br>H 03 L |

**Le présent rapport a été établi pour toutes les revendications**

| Lieu de la recherche | Date d'achèvement de la recherche | Examinateur |
|---|---|---|
| LA HAYE | 19-02-1990 | BALBINOT H. |

CATEGORIE DES DOCUMENTS CITES

X : particulièrement pertinent à lui seul
Y : particulièrement pertinent en combinaison avec un
   autre document de la même catégorie
A : arrière-plan technologique
O : divulgation non-écrite
P : document intercalaire

T : théorie ou principe à la base de l'invention
E : document de brevet antérieur, mais publié à la
   date de dépôt ou après cette date
D : cité dans la demande
L : cité pour d'autres raisons
..............................................................................
& : membre de la même famille, document correspondant

EPO FORM 1503 03.82 (P0402)